# EUROPÄISCHE PATENTSCHRIFT

(11) **EP 3 822 590 B1**
(45) Veröffentlichungstag und Bekanntmachung des Hinweises auf die Patenterteilung: **29.06.2022**
(21) Anmeldenummer: 19208557.9
(22) Anmeldetag: 12.11.2019
(51) Int. Cl.: G01D 11/24, G01N 33/00, G12B 9/02

(54) **EXPLOSIONSGESCHÜTZTES DRUCKFESTES GEHÄUSE**
EXPLOSION-PROOF PRESSURE-TIGHT HOUSING
BOÎTIER RÉSISTANT À LA PRESSION PROTÉGÉ CONTRE LES EXPLOSIONS

(43) Veröffentlichungstag der Anmeldung: 19.05.2021
(73) Patentinhaber: Siemens Aktiengesellschaft, 80333 München (DE)
(72) Erfinder: Pfalzer, Ulrich, 75056 Sulzfeld (DE)

(56) Entgegenhaltungen:
- DE-A1-102011 015 646
- DE-A1-102015 223 362
- DE-A1-102017 128 816

## Beschreibung

Die Erfindung betrifft ein explosionsgeschütztes druckfestes Gehäuse für elektrische Betriebsmittel, die z. B. einen optischen Gasanalysator umfassen können.

Elektrotechnische Erzeugnisse, die in einer explosionsgefährdenden Umgebung installiert und betrieben werden, müssen den gesetzlichen Schutzmaßnahmen zur Vermeidung wirksamer Zündquellen im Rahmen des Explosionsschutzes entsprechen. Gehäuse in der Zündschutzart "Druckfeste Kapselung" ("Ex d") müssen dem Druck einer Explosion eines explosionsfähigen Gemisches im Inneren standhalten und die Übertragung der Explosion nach außen verhindern. Der Explosionsdruck hängt vom freien inneren Volumen und von der Form des Gehäuses ab. Das Gehäuse muss entsprechend stabil sein. Um zu verhindern, dass die Explosion aufgrund von Flammendurchschlag (Zünddurchschlag) durch Gehäuseöffnungen nach außen übertragen wird, darf bei allen nach außen führenden Gehäusespalten eine minimale Spaltlänge nicht unterschritten und eine maximale Spaltweite nicht überschritten werden. Ferner darf die Oberflächentemperatur an der Gehäuseaußenwand die Zündtemperatur der umgebenden explosionsfähigen Atmosphäre nicht überschreiten.

Der Verschluss von Gehäusen erfolgt bisher oft über ein Verschlussteil mit einem Gewinde oder mit vielen einzelnen Schrauben oder Verbindungsteilen. Bei einem Gewinde mit großem Durchmesser besteht das Problem , dass es sorgfältig eingeschraubt werden muss, um nicht zu verkanten, und dass es sich oft nur schwer wieder öffnen lässt. Das Verschließen und Öffnen des Gehäuses unter Verwendung vieler einzelner Schrauben ist sehr zeitaufwendig ist.

Aus der EP 2 175 707 A2 ist ein Gehäuse mit mindestens einem zylindrischen Aufnahmeteil für elektrische Betriebsmittel und mit einem das Aufnahmeteil über einen Bajonettverschluss verschließenden Verschlussteil bekannt. Das Aufnahmeteil weist über den Umfang verteilte Zapfen auf, während die Innenwand des Verschlussteils über den Umfang verteilte in Steckrichtung verlaufende Längsnuten enthält, die an ihren Enden in eine quer zur Steckrichtung verlaufende Quernuten zur Aufnahme der Zapfen münden. Das Gehäuse kann mehrere voneinander getrennte Innenräume enthalten, wenn z. B. bei dem entsprechenden elektrischen oder elektronischen Gerät ein Explosionsschutz realisiert sein muss.

Um in der Verbindungsposition von Aufnahmeteil und Verschlussteil immer einen gleichen Spalt, vorzugsweise mit der Spaltweite Null, zu realisieren, sind an dem einen Teil senkrecht zur Steckrichtung verlaufende Flächen und an dem anderen Teil korrespondierende Gegenflächen ausgebildet, die in der Verbindungsposition aneinander anliegen.

Ferner kann an dem einen Teil eine Rastausnehmung und an dem andren Teil eine Rastnase ausgebildet sein, die in der Verbindungsposition in die Rastausnehmung einrastet und zum Lösen der Bajonettverbindung ein spezielles Werkzeug erfordert. Aus der WO 2007/090421 A1 ist ein modular aufgebautes Feldgerät für die Prozessinstrumentierung bekannt. Die verschiedenen Module des Feldgerätes sind über einen Bajonettverschluss miteinander verbunden.

Die DE102011015646 offenbart zwei mit einander zugewandten Öffnungen koaxial aneinander angesetzte haubenförmige Gehäuseteile (5, 6). Die beiden Gehäuseteile (5, 6) sind an ihren aneinander angrenzenden Seitenwänden (5b, 6b) durch eine Bajonettverbindungseinrichtung (45) aneinander fixiert. Die beiden Gehäuseteile (5, 6) sind so gestaltet, dass die Verriegelungsvorsprünge (46a, 46b) der Bajonettverbindungseinrichtung (45) von außen her unsichtbar verdeckt sind.

Der Erfindung liegt die Aufgabe zugrunde, ein explosionsgeschütztes druckfestes Gehäuse mit einem Aufnahmeteil für elektrische Betriebsmittel und einem das Aufnahmeteil über einen Bajonettverschluss verschließenden Verschlussteil anzugeben, das aufgrund von einfach gestalteten Teilen sehr einfach und kostengünstig zu fertigen ist und darüber hinaus einfach zu handhaben, insbesondere zu einfach zu öffnen und zu schließen ist.

Gemäß der Erfindung wir die Aufgabe durch das in Anspruch 1 definierte explosionsgeschützte druckfeste Gehäuse gelöst, von dem vorteilhafte Weitebildungen in den Unteransprüchen angegeben sind.

Gegenstand der Erfindung ist somit ein explosionsgeschütztes druckfestes Gehäuse mit einem Aufnahmeteil für elektrische Betriebsmittel und mit einem das Aufnahmeteil über einen Bajonettverschluss verschließenden Verschlussteil,
- wobei das Verschlussteil einen zylindrischen Abschnitt aufweist, mit dem es unter Ausbildung eines zünddurchschlagsicheren Spaltes in eine zylindrische Außenwand oder einen zylindrischen Außenwandabschnitt des Aufnahmeteils eingeschoben ist,
- wobei der zylindrische Abschnitt des Verschlussteils über den Umfang verteilte Zapfen aufweist und die zylindrische Außenwand oder der zylindrische Außenwandabschnitt des Aufnahmeteils über den Umfang verteilte in Steckrichtung verlaufende Längsschlitze enthält, an deren Enden sich quer zur Steckrichtung verlaufende kurze Querschlitze zur Aufnahme der Zapfen anschließen,
- wobei auf dem Verschlussteil ein Sicherungsteil aufgeschoben ist, das über den Umfang verteilte Sicherungselemente aufweist, die in die Längsschlitze eingreifen und dabei ein Herausdrehen der Zapfen aus den Querschlitzen verhindern, und
- wobei das Sicherungsteil mittels mindestens eines ausschließlich mittels eines Werkzeuges lösbaren Befestigungsmittels an dem Verschlussteil befestigt ist.

Das erfindungsgemäße Gehäuse besteht aus wenigen Teilen, die einfach zusammengebaut und demontiert werden können. Die Teile selbst sind sehr einfach aufgebaut und lassen sich daher einfach und kostengünstig mit nur geringem Materialaufwand fertigen. So kann das Verschlussteil als einfacher Deckel mit einem zylindrischen Abschnitt ausgebildet sein, der über die Bajonettverbindung durch eine einfache Steck- und Drehbewegung in die zylindrische Außenwand oder einen zylindrischen Außenwandabschnitt des Aufnahmeteils eingesetzt und mit dem Aufnahmeteil verriegelt wird. Der Bajonettverschluss wird durch einfaches Aufschieben des Sicherungsteils auf das Verschlussteil gegen unbeabsichtigtes Lösen gesichert. Um zu verhindern, dass das Sicherungsteil unberechtigterweise entfernt wird, ist es an dem Verschlussteil mittels eines Befestigungsmittels befestigt, das nur mit Hilfe eines speziellen Werkzeuges gelöst werden kann. Bei dem Befestigungsmittel kann es sich in einfach um eine Sicherungsschraube oder ein elastisches Rastteil handeln, das in eine entsprechende Ausnehmung in dem Verschlussteil eingreift. Diese Ausnehmung kann als Ringnut ausgebildet sein, so dass das Sicherungsteil in jeder beliebigen Drehwinkelposition auf das Verschlussteil aufgeschoben und anschließend gesichert werden kann.

Im baulich einfachsten Fall weist das Sicherungsteil einen auf das Verschlussteil aufschiebbaren Ringabschnitt auf bzw. ist als Ring ausgebildet, an dem die Sicherungselemente in Form von sich in Steckrichtung erstreckenden Stiften ausgebildet sind. Alternativ kann das Sicherungsteil einen auf das Aufnahmeteil aufschiebbaren zylindrischen Rohrabschnitt aufweisen, auf dessen Innenseite die Sicherungselemente in Form von sich in Steckrichtung erstreckenden Rippen ausgebildet sind. Dabei werden das Sicherungsteil mit den Sicherungselementen in den Längsschlitzen und die Zapfen in den Querschlitzen in vorteilhafter Weise durch den zylindrischen Rohrabschnitt abgedeckt. Im Falle des Ringabschnitts oder Rings mit den Stiften kann die Abdeckung auch durch eine Manschette erfolgen, die an der Stelle der Bajonettverbindung auf das Gehäuse aufgeschoben wird. Eine solche Manschette kann eine eckiger Außenkontur aufweisen, die das vorzugsweise zylindrische Gehäuse beim Hantieren, z. B. dem Ein- oder Ausbau der elektrischen Betriebsmittel, gegen Wegrollen sichert.

Im Falle von elektrooptischen Betriebsmitteln wie z. B. einem optischen Gasanalysator, der ein Messgas außerhalb des Gehäuses misst, kann das Verschlussteil ein optisches Fenster enthalten, das vorzugsweise außermittig zur Zylinderachse des Verschlussteils angeordnet ist, so dass für den Gasanalysator unabhängig von seiner Einbauposition in dem Aufnahmeteil immer eine Sichtverbindung nach außen realisiert werden kann, indem das Verschlussteil in einer geeigneten Drehwinkelposition an dem Aufnahmeteil verriegelt wird.

In Folgenden wird die Erfindung anhand eines in der Zeichnung dargestellten Ausführungsbeispiels beispielhaft erläutert. Im Einzelnen zeigen
- Fig. 1: ein Sicherungsteil in Seitenansicht,
- Fig. 2: das Sicherungsteil in Draufsicht,
- Fig. 3: ein Verschlussteil in Seitenansicht,
- Fig. 4: das Verschlussteil in Draufsicht,
- Fig. 5: ein Aufnahmeteil für elektrische Betriebsmittel in Seitenansicht und teilweise im Schnitt,
- Fig. 6: ein aus dem Aufnahmeteil, Verschlussteil und Sicherungsteil bestehendes explosionsgeschütztes druckfestes Gehäuse,
- Fig. 7: eine Manschette mit eckiger Außenkontur und
- Fig. 8: ein alternatives Ausführungsbeispiel für das Sicherungsteil.

In den Figuren sind gleiche Teile mit gleichen Bezugszeichen versehen. Die Darstellungen sind schematisch und nicht maßstäblich.

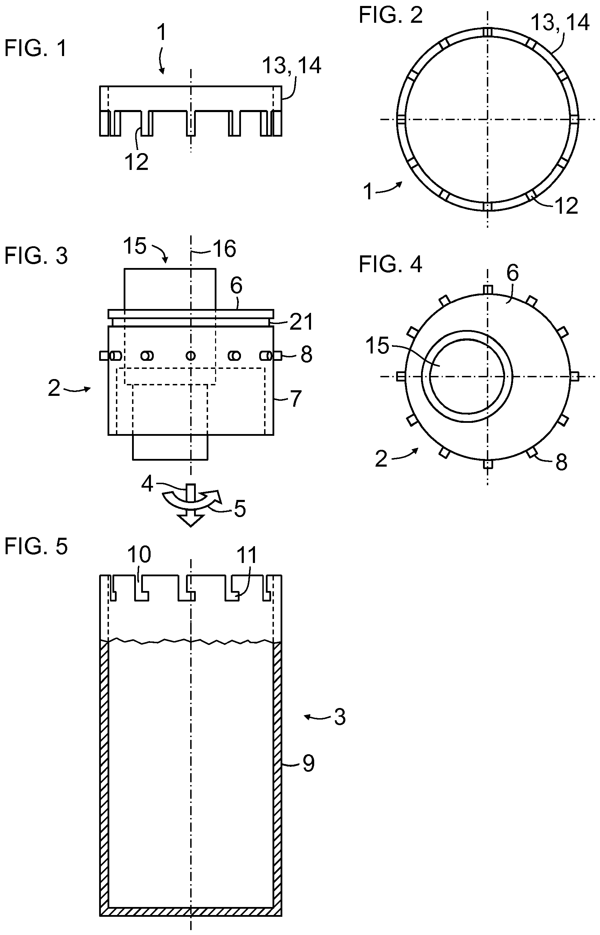

Fig. 1 und Fig. 2 zeigen ein Sicherungsteil 1, welches dazu dient, ein in Fig. 3 und Fig. 4 gezeigtes Verschlussteil 2 gegen versehentliches oder unberechtigtes Entfernen vom einem in Fig. 5 gezeigtes Aufnahmeteil 3 für elektrische Betriebsmittel zu sichern.

Das Aufnahmeteil 3 und das Verschlussteil 2 sind dazu ausgebildet, über einen Bajonettverschluss durch eine Steckbewegung 4 und anschließende Drehbewegung 5 miteinander verbunden zu werden und dabei einen zünddurchschlagsicheren Spalt, insbesondere einen Nullspalt zwischen beiden Teilen 2, 3 auszubilden. Dazu ist das Verschlussteil 2 in Form eines Deckels mit einem scheibenförmigen Abschnitt 6 und einem zylindrischen Abschnitt 7 ausgebildet, der über den Umfang verteilte radial abstehende Zapfen 8 aufweist.

Das Aufnahmeteil 3 kann, wie hier gezeigt, als Hohlzylinder mit einem Boden und einem offenen Ende ausgebildet sein, an dem die zylindrische Außenwand 9 des Aufnahmeteils 3 über den Umfang verteilte und in Steckrichtung 4 verlaufende Längsschlitze 10 enthält, von deren Enden quer zur Steckrichtung verlaufende kurze Querschlitze 11 zur Aufnahme der Zapfen 8 des Verschlussteils 2 abgehen. Alternativ kann es sich bei dem Aufnahmeteil 3 um einen beidseitig offenen Hohlzylinder handeln, der an beiden Enden über einen Bajonettverschluss mit jeweils einem Verschlussteil verschließbar ist. Das Aufnahmeteil 3 kann auch eine andere Form als die eines Zylinders haben und nur an dem Ende, wo es mit dem Verschlussteil verschließbar ist, einen zylindrischen Außenwandabschnitt aufweisen.

Der Außendurchmesser des zylindrischen Abschnitts 7 des Verschlussteils 2 ist nur minimal kleiner als der Innendurchmesser der zylindrischen Außenwand 9 des Aufnahmeteils 3, so dass sich nach dem Einstecken und Eindrehen des Verschlussteils 2 in das Aufnahmeteil 3 zwischen dem zylindrischen Abschnitt 7 und der zylindrischen Außenwand 9 ein zünddurchschlagsicherer Spalt bildet. Ein für die Zünddurchschlagsicherheit wesentliches Spaltmaß ist dabei die Weglänge aus dem Inneren des Aufnahmeteils 3 durch den Spalt nach außen, die durch die Höhe (oder Länge) des zylindrischen Abschnitts 7 bestimmt ist.

Nach dem Einstecken und Eindrehen des Verschlussteils 2 in das Aufnahmeteil 3 kommen die Zapfen 8 in den Querschlitzen 11 zu liegen und verriegeln das Verschlussteil 2 gegenüber dem Aufnahmeteil 3. Das Sicherungsteil 1 weist über den Umfang verteilte Sicherungselemente 12 auf, die beim Aufschieben des Sicherungsteil 1 auf das Verschlussteil 2 in die Längsschlitze 10 in dem Aufnahmeteil 3 eingreifen und dadurch ein Herausdrehen der Zapfen 8 aus den Querschlitzen 11 verhindern. Bei dem in Fig. 1 und Fig. 2 gezeigten Ausführungsbeispiel weist das Sicherungsteil 1 einen auf das Verschlussteil 2 aufschiebbaren Ringabschnitt 13 auf bzw. ist als Ringteil 14 ausgebildet, an dem die Sicherungselemente 12 in Form von sich in Steckrichtung 4 erstreckenden Stiften ausgebildet sind. Das Ringteil 14 umgibt das Verschlussteil 2, ohne den scheibenförmigen Abschnitt 6 abzudecken, so dass dieser von außen zugänglich bleibt. Dies ist wichtig, wenn das Verschlussteil 2 beispielsweise hier nicht gezeigte Kabeldurchführungen in dem scheibenförmigen Abschnitt 6 enthält oder, wie hier gezeigt, ein optisches Fenster 15 für ein in dem Aufnahmeteil 3 untergebrachtes elektrooptisches Gerät, beispielsweise ein optischer Gasanalysator (z. B. Laserspektrometer) enthält. Das optische Fenster 15 ist hier außermittig zur Zylinderachse 16 des Verschlussteils 2 angeordnet, so dass weitgehend unabhängig von der jeweiligen Einbauposition des elektrooptisches Geräts in dem Aufnahmeteil 3 über die Einsteckposition (Drehwinkelposition) des Verschlussteils 2 in dem Aufnahmeteil 3 immer eine Sichtverbindung zwischen dem elektrooptischen Gerät und einem vorgegebenen Punkt außerhalb des explosionsgeschützten druckfesten Gehäuses hergestellt werden kann.

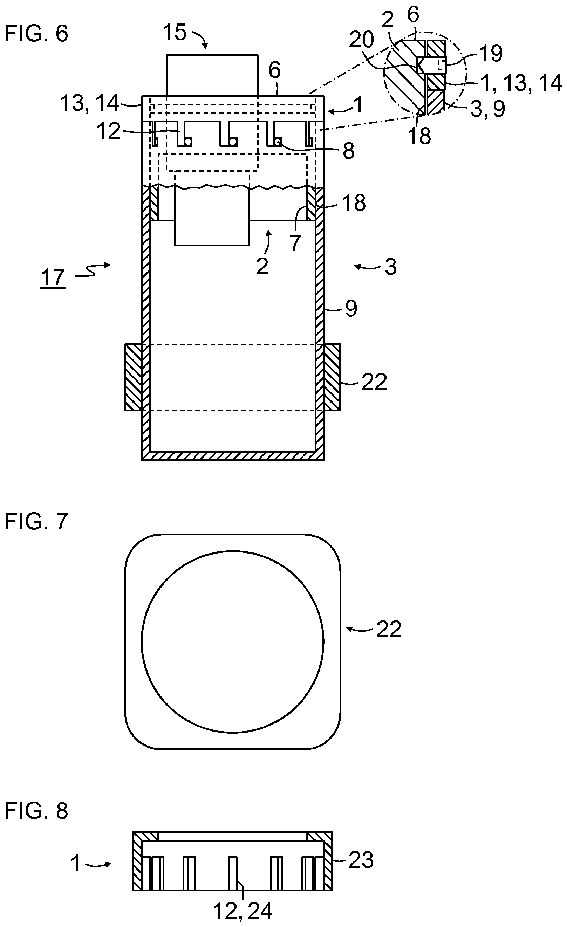

Fig. 6 zeigt das aus dem Aufnahmeteil 3, Verschlussteil 2 und Sicherungsteil 1 zusammengesetzte explosionsgeschützte druckfeste Gehäuse 17, wobei zwischen dem zylindrischen Abschnitt 7 des Verschlussteils 2 und der zylindrischen Außenwand 9 des Aufnahmeteils 3 der zünddurchschlagsichere Spalt 18 ausgebildet ist. Die Zapfen 8 des Verschlussteils 8 sind durch die Sicherungselemente 12 des Sicherungsteils 1 in den Querschlitzen 11 (Fig. 5) fixiert. Wie die vergrößerte Einzelheit der oberen rechten Ecke des Gehäuses 17 zeigt, ist das Sicherungsteil 1 mittels eines Befestigungsmittels 19, hier in Form einer Sicherungsschraube, an dem Verschlussteil 2 befestigt, so dass das Verschlussteil 2 wegen der in den Querschlitzen 11 (Fig. 5) durch die Sicherungselemente 12 fixierten Zapfen 8 nicht unbeabsichtigt von dem Aufnahmeteil 3 lösbar ist. Um ein unberechtigtes Entfernen des Verschlussteils 2 zu verhindern, ist das Befestigungsmittel 19 in an sich bekannter Weise derart ausgestaltet, dass es nur mit einem speziellen Werkzeug lösbar ist. Das Befestigungsmittel 19, bei dem es sich beispielsweise auch um eine elastische oder unter Federkraft stehende Rastnase oder Rastzunge handeln kann, greift in eine Ausnehmung 20 an dem Verschlussteil ein, die hier in Form einer Umlaufnut 21 (Fig. 3) in dem Verschlussteil 2 ausgebildet ist.

Auf das zylinderförmige Aufnahmeteil 3 kann eine Manschette 22 mit eckiger Außenkontur aufgeschoben werden, um ein Wegrollen des Aufnahmeteils 3 beim Einbau der Betriebsmittel zu verhindern. Fig. 7 zeigt die Manschette 22 in Draufsicht. Die Manschette 22 oder eine weitere Manschette kann insbesondere an der Stelle der Bajonettverbindung platziert werden, um das Sicherungsteil 1 mit den Sicherungselementen 12 in den Längsschlitzen 10 und die Zapfen 8 in den Querschlitzen 11 abzudecken.

Fig. 8 zeigt eine alternative Ausführungsform des Sicherungsteils 1 mit einen zylindrischen Rohrabschnitt 23, der auf das Aufnahmeteil 3 aufschiebbar ist und auf dessen Innenseite die Sicherungselemente 12 in Form von sich in Steckrichtung 4 (Fig. 3) erstreckenden Rippen 24 ausgebildet sind.

## Patentansprüche

1. Explosionsgeschütztes druckfestes Gehäuse (17) mit einem Aufnahmeteil (3) für elektrische Betriebsmittel und mit einem das Aufnahmeteil (3) über einen Bajonettverschluss verschließenden Verschlussteil (2),
- wobei das Verschlussteil (2) einen zylindrischen Abschnitt (7) aufweist, mit dem es unter Ausbildung eines zünddurchschlagsicheren Spaltes (18) in eine zylindrische Außenwand (9) oder einen zylindrischen Außenwandabschnitt des Aufnahmeteils (3) eingeschoben ist,
- wobei der zylindrische Abschnitt (7) des Verschlussteils (2) über den Umfang verteilte Zapfen (8) aufweist und die zylindrische Außenwand (9) oder der zylindrische Außenwandabschnitt des Aufnahmeteils (3) über den Umfang verteilte und in Steckrichtung (4) verlaufende Längsschlitze (10) enthält, an deren Enden sich quer zur Steckrichtung (4) verlaufende kurze Querschlitze (11) zur Aufnahme der Zapfen (8) anschließen,
- wobei auf dem Verschlussteil (2) ein Sicherungsteil (1) aufgeschoben ist, das über den Umfang verteilte Sicherungselemente (12) aufweist, die in die Längsschlitze (10) eingreifen und dabei ein Herausdrehen der Zapfen (8) aus den Querschlitzen (11) verhindern, und
- wobei das Sicherungsteil (1) mittels mindestens eines ausschließlich mittels eines Werkzeuges lösbaren Befestigungsmittels (19) an dem Verschlussteil (2) befestigt ist.

2. Explosionsgeschütztes druckfestes Gehäuse (17) nach Anspruch 1, **dadurch gekennzeichnet, dass** das Sicherungsteil (1) einen auf das Verschlussteil (2) aufschiebbaren Ringabschnitt (13) aufweist, an dem die Sicherungselemente (12) in Form von sich in Steckrichtung (4) erstreckenden Stiften ausgebildet sind.

3. Explosionsgeschütztes druckfestes Gehäuse (17) nach Anspruch 1, **dadurch gekennzeichnet, dass** das Sicherungsteil (1) einen auf das Aufnahmeteil (3) aufschiebbaren zylindrischen Rohrabschnitt (23) aufweist, auf dessen Innenseite die Sicherungselemente (12) in Form von sich in Steckrichtung (4) erstreckenden Rippen (24) ausgebildet sind.

4. Explosionsgeschütztes druckfestes Gehäuse (17) nach Anspruch 1, 2 oder 3, **dadurch gekennzeichnet, dass** das Befestigungsmittel (19) ein elastisches Rastteil aufweist, das in eine Ausnehmung (20) an dem Verschlussteil (2) eingreift.

5. Explosionsgeschütztes druckfestes Gehäuse (17) nach Anspruch 1, 2 oder 3, **dadurch gekennzeichnet, dass** das Befestigungsmittel (19) eine Sicherungsschraube aufweist, die in eine Ausnehmung (20) an dem Verschlussteil (2) eingreift.

6. Explosionsgeschütztes druckfestes Gehäuse (17) nach Anspruch 4 oder 5, **dadurch gekennzeichnet, dass** die Ausnehmung (20) in Form einer Umlaufnut (12) in dem Verschlussteil (2) ausgebildet ist.

7. Explosionsgeschütztes druckfestes Gehäuse (17) nach einem der vorangehenden Ansprüche, **dadurch gekennzeichnet, dass** das Aufnahmeteil (3) für elektrooptische Betriebsmittel ausgebildet ist und das Verschlussteil (2) ein optisches Fenster (15) enthält.

8. Explosionsgeschütztes druckfestes Gehäuse nach (17) Anspruch 7, **dadurch gekennzeichnet, dass** das optische Fenster (15) außermittig zur Zylinderachse (16) des Verschlussteils (2) angeordnet ist.

## Claims

1. Explosion-protected pressure-resistant housing (17) with a receiving part (3) for electric operating means and with a closure part (2) which closes the receiving part (3) by way of a bayonet catch,
- wherein the closure part (2) has a cylindrical segment (7), with which by forming a flameproof joint (18) it is inserted into a cylindrical outer wall (9) or a cylindrical outer wall segment of the receiving part (3),
- wherein the cylindrical segment (7) of the closure part (2) has pins (8) distributed across the periphery and the cylindrical outer wall (9) or the cylindrical outer wall segment of the receiving part (3) contains longitudinal slots (10) which run in a distributed manner across the periphery and in the plug direction (4), at the ends of which longitudinal slots short transverse slots (11) which run at right angles to the plug direction (4) connect for receiving the pins (8),
- wherein a locking part (1) is slid onto the closure part (2), said locking part (1) having locking elements (12) distributed across the periphery which engage in the longitudinal slots (10) and in the process prevent the pins (8) from rotating out of the transverse slots (11), and
- wherein the locking part (1) is fastened to the closure part (2) by means of at least one fastening means (19) which can be detached exclusively by means of a tool.

2. Explosion-protected pressure-resistant housing (17) according to claim 1, **characterised in that** the locking part (1) has an annular segment (13) which can be slid onto the closure part (2), on which annular segment (13) the locking elements (12) are embodied in the form of pins which extend in the plug direction (4).

3. Explosion-protected pressure-resistant housing (17) according to claim 1, **characterised in that** the locking part (1) has a cylindrical pipe segment (23) which can be slid onto the receiving part (3), on the interior of which the locking elements (12) are embodied in the form of ribs (24) which extend in the plug direction (4).

4. Explosion-protected pressure-resistant housing (17) according to claim 1, 2 or 3, **characterised in that** the fastening means (19) has an elastic snap-fit part, which engages into a cut-out (20) on the closure part (2).

5. Explosion-protected pressure-resistant housing (17) according to claim 1, 2 or 3, **characterised in that** the fastening means (19) has a lock screw, which engages into a cut-out (20) on the closure part (2).

6. Explosion-protected pressure-resistant housing (17) according to claim 4 or 5, **characterised in that** the cut-out (20) is embodied in the form of a peripheral groove (12) in the closure part (2).

7. Explosion-protected pressure-resistant housing (17) according to one of the preceding claims, **characterised in that** the receiving part (3) is embodied for electro-optical operating means and the closure part (2) contains an optical window (15).

8. Explosion-protected pressure-resistant housing (17) according to claim 7, **characterised in that** the optical window (15) is arranged eccentrically with respect to the cylinder axis (16) of the closure part (2).

## Revendications

1. Boîtier (17) résistant à la pression et à l'épreuve de l'explosion comprenant une pièce (3) de réception d'un moyen électrique de fonctionnement et comprenant une pièce (2) de fermeture fermant la pièce (3) de réception par une fermeture à baïonnette,
- dans lequel la pièce (2) de fermeture a une partie (7) cylindrique, par laquelle elle est insérée avec formation d'un intervalle (18) d'anti-décharge d'étincelle dans une paroi (9) extérieure cylindrique ou dans une partie de paroi extérieure cylindrique de la pièce (3) de réception,
- dans lequel la partie (7) cylindrique de la pièce (2) de fermeture a des tenons (8) répartis sur le pourtour et la paroi (9) extérieure cylindrique ou la partie extérieure cylindrique de la pièce (3) de réception comporte des boutonnières (10) réparties sur le pourtour et s'étendant dans la direction (4) d'enfichage, à l'extrémité desquelles se raccorde, pour la réception des tenons (8), des fentes (11) transversales courtes s'étendant transversalement à la direction (4) d'enfichage,
- dans lequel, sur la pièce (2) de fermeture est insérée une pièce (1) de fixation, qui a, répartis sur le pourtour, des éléments (12) de fixation, qui pénètrent dans les boutonnières (10) et empêchent les tenons (8) de sortir par rotation des fentes (11) transversales, et
- dans lequel la pièce (1) de fixation est fixée à la pièce (2) de fermeture au moyen d'au moins un moyen (19) de fixation amovible seulement au moyen d'un outil.

2. Boîtier (17) résistant à la pression et à l'épreuve de l'explosion suivant la revendication 1, **caractérisé en ce que** la pièce (1) de fixation a une partie (13) annulaire, qui peut être enfilée sur la pièce (2) de fermeture et sur laquelle sont constitués les éléments (12) de fixation sous la forme de broches s'étendant dans la direction (4) d'enfichage.

3. Boîtier (17) résistant à la pression et à l'épreuve de l'explosion suivant la revendication 1, **caractérisé en ce que** la pièce (1) de fixation a une partie (23) tubulaire cylindrique, qui peut être enfilée sur la pièce (3) de réception et sur la face intérieure de laquelle les éléments (12) de fixation sont constitués sous la forme de nervures (24) s'étendant dans la direction (4) d'enfichage.

4. Boîtier (17) résistant à la pression et à l'épreuve de l'explosion suivant l'une des revendications 1, 2 ou 3, **caractérisé en ce que** le moyen (19) de fixation a une partie élastique d'encliquetage, qui pénètre dans un évidement (20) de la pièce (2) de fermeture.

5. Boîtier (17) résistant à la pression et à l'épreuve de l'explosion suivant l'une des revendications 1, 2 ou 3, **caractérisé en ce que** le moyen (19) de fixation a une vis de fixation, qui pénètre dans un évidement (20) de la pièce (2) de fermeture.

6. Boîtier (17) résistant à la pression et à l'épreuve de l'explosion suivant l'une des revendications 4 ou 5, **caractérisé en ce que** l'évidement (20) est constitué sous la forme d'une rainure (12) faisant le tour de la pièce (2) de fermeture.

7. Boîtier (17) résistant à la pression et à l'épreuve de l'explosion suivant l'une des revendications précédentes, **caractérisé en ce que** la pièce (3) de réception est constituée pour des moyens de fonctionnement électro-optiques et la pièce (2) de fermeture comporte un hublot (15) optique.

8. Boîtier (17) résistant à la pression et à l'épreuve de l'explosion suivant la revendication 7, **caractérisé en ce que** le hublot (15) optique est disposé de manière excentrée par rapport à l'axe (16) du cylindre de la pièce (2) de fermeture.
